# EUROPEAN PATENT SPECIFICATION

(11) **EP 1 897 076 B1**
(45) Date of publication and mention of the grant of the patent: **25.11.2009**
(21) Application number: 05771227.5
(22) Date of filing: 29.06.2005
(51) Int. Cl.: G08B 21/00, B60C 23/04

(54) **RFID TO STORE SAW CALIBRATION COEFFICIENTS**
RFID ZUM SPEICHERN VON SAW-KALIBRATIONSKOEFFIZIENTEN
ETIQUETTE D'IDENTIFICATION PAR RADIO-FREQUENCE DESTINEE AU STOCKAGE DE COEFFICIENTS D'ETALONNAGE ASSOCIES A DES DISPOSITIFS A ONDES ACOUSTIQUES DE SURFACE

(43) Date of publication of application: 12.03.2008
(73) Proprietor: Michelin Recherche et Technique S.A., 1763 Granges-Paccot (CH); Société de Technologie Michelin, 63000 Clermont-Ferrand (FR)
(72) Inventor: O'BRIEN, George P., Piedmont, South Carolina 29673 (US)
(74) Representative: Schlief, Thomas P.
(86) International application number: PCT/US2005/023579
(87) International publication number: WO 2007/005020

(56) References cited:
- WO-A-02/07993
- WO-A-2005/052533
- US-A- 5 656 993
- US-A1- 2004 135 675
- US-B1- 6 271 748
- US-B1- 6 271 748
- US-B1- 6 486 776
- US-B2- 6 765 493

## Description

### FIELD OF THE INVENTION

The present technology generally concerns a method of interrogating resonator elements such as those present in surface acoustic wave (SAW) devices. Such SAW devices may be incorporated in a tire or wheel assembly for sensing such physical parameters as ambient temperature and pressure. The present technology relates to the maintenance of associated calibration constants for such surface acoustic wave (SAW) devices.

### BACKGROUND OF THE INVENTION

The incorporation of electronic devices with tire structures yields many practical advantages. Tire electronics may include sensors and other components for relaying tire identification parameters and also for obtaining information regarding various physical parameters of a tire, such as temperature, pressure, number of tire revolutions, vehicle speed, etc. Such performance information may become useful in tire monitoring and warning systems, and may even potentially be employed with feedback systems to regulate proper tire pressure levels.

Yet another potential capability offered by electronics systems integrated with tire structures corresponds to asset tracking and performance characterization for commercial vehicular applications. Commercial truck fleets, aviation craft and earth mover/mining vehicles are all viable industries that could utilize the benefits of tire electronic systems and related information transmission. Radio frequency identification (RFID) tags can be utilized to provide unique identification for a given tire, enabling tracking abilities for a tire. Tire sensors can determine the distance each tire in a vehicle has traveled and thus aid in maintenance planning for such commercial systems. Vehicle location and performance can be optimized for more expensive applications such as those concerning earth-mining equipment.

One particular type of sensor, or condition-responsive device, that has been utilized to determine various parameters related to a tire or wheel assembly is an acoustic wave device, such as a surface acoustic wave (SAW) device. Such SAW devices typically include at least one resonator element consisting of interdigitated electrodes deposited on a piezoelectric substrate. When an electrical input signal is applied to a SAW device, selected electrodes cause the SAW to act as a transducer, thus converting the input signal to a mechanical wave on the substrate. These same electrodes then reverse the transducer process and generate an electrical output signal. A change in the output signal from a SAW device, such as a change in frequency, phase and/or amplitude of the output signal, corresponds to changing characteristics in the propagation path of the SAW device.

In some SAW device embodiments, monitored resonant frequency and any changes thereto provide sufficient information to determine parameters such as temperature, pressure, and strain to which a SAW device is subjected. SAW devices capable of such operation may include three separate resonator elements. Specific examples of such a SAW device correspond to those developed by Transense Technologies, PLC, specific aspects of which are disclosed in published U.S. Patent Application Nos. 2002/0117005 (Viles et al.) and 2004/0020299 (Freakes et al.), both of which are incorporated herein by reference for all purposes.

US 2007/0089525 A1 describes a sealing member for mounting a sensor substrate, which has on its lower surface a SAW element, on a supporting substrate. A sealing space is formed by the sensor substrate, the supporting substrate, and the sealing member. The SAW element, which serves for detecting pressure, is sealed hermetically in the sealing space.

SAW devices in the tire industry have typically been implemented as passive devices, and are interrogated by remote transceiver devices that include circuitry for both transmitting a signal to a SAW device as well as for receiving a signal from the SAW device. The remote transceiver device, or interrogator, transmits energizing signals of varied frequencies from a remote location to the SAW device. The SAW device stores some of this transmitted energy during excitation and may then transmit a corresponding output signal. A comparison of the interrogator's transmitted and received signals indicates when the SAW device is excited at its resonant frequency. Examples of SAW interrogation technology can be found in U.S. Patent No. 6,765,493 (Lonsdale et al.) and in UK Patent Application GB 2,381,074 (Kalinin et al), both of which are incorporated herein by reference for all purposes.

US 2004/0135675 A1 discloses an electronics assembly for integration with a tire structure or in another environment. The electronics assembly comprises a condition-responsive device like a SAW sensor to sense information about at least one physical parameter, an RF source connected to said device, an antenna for receiving an output signal from said device and for transmitting an RF signal indicating said at least one physical parameter and at least one switching element configured to selectively control the effective transmission of said RF signal. Calibration steps are not specifically discussed in this document.

US 6,486,776 B1 discloses an RF transponder capable of measuring temperature and pressure within a tire. The transponder includes circuitry for controlling windows of time during which real-time temperature and pressure measurements are made, and for storing calibration data, transponder ID number as the like. The transponder is calibrated prior to its installation in the tire by using an EEPROM for holding calibration constants that a reader system uses to convert temperature and pressure counts into temperature and pressure readings.

US 6,271,748 B1 discloses a tire condition monitoring system comprising a wheel transmitter unit for each wheel of a vehicle, wherein the transmitter has sensors for sensing pressure and temperature in and rotation of the wheel. Before placing the transmitter in a wheel, the transmitter is placed in a test chamber in which it is exposed to calibrated pressures. Thus, calibration data representing the behaviour of the pressure sensor in response to both pressure and temperature can be stored in order to produce a calibrated output representing directly the pressure applied to the transducer.

Because the resonant frequency of each resonator element in a SAW varies not only with given input parameters but also based on manufacturing tolerances, tire installation conditions and other factors, SAW interrogators must typically make allowances for such variations in order to provide an accurate reflection of the sensed data. While various interrogation systems have been developed, no one design has emerged that offers technology for effecting SAW interrogation with improved data extraction accuracy levels as hereafter presented in accordance with the present technology.

### SUMMARY OF THE INVENTION

In view of the recognized features encountered in the prior art and addressed by the present subject matter, an improved methodology for providing accurate sensor information based on data read from SAW based devices has been developed as set out in the appended claims.

In an exemplary configuration, SAW based devices may include an acoustic wave device connected as a feedback element in an oscillator/amplifier and may be further coupled to an antenna element, thus forming an active transmitter arrangement. The acoustic wave device determines the carrier frequency (or frequencies) produced by such an active transmitter, and therefore, the frequency (or frequencies) of the transmitted RF signal represents one or more sensed parameters with the acoustic wave device itself functioning as a sensor. At the same time, the transmitted signal amplitude may be controlled by means of a separate circuit connected to the oscillator amplifier.

In one of their simpler forms, the transmitted signal from a SAW based device may be switched on and off in a timed sequence, but other methods are possible. Positive aspects of this information transmission methodology include circuit simplification and power savings. For example, instead of requiring the circuitry in the tire to measure the sensed parameters, covert them to digital format, and encode them in a transmitted digital data stream, the sensed parameter information is conveyed through the transmitted RF frequency. Such methodology provides for the transmission of any other information desired, however complex or simple, by amplitude modulation of the transmitted signal. Such a circuit configuration provides for the ability to actively transmit a combination of information from integrated tire electronics to a remote receiver location. The combination of information may correspond to the physical parameters sensed by the acoustic wave device as well as digital data superimposed on the RF signal emitted by the acoustic wave device by selectively switching the amplifier on and off.

Another positive aspect of this type of device is that versatility is afforded to the types of information that can be transmitted via the electronics assemblies. Such information can include sensed information relating to parameters such as temperature and pressure associated with a tire or wheel assembly. Other information may include selected combinations of a unique tag identification, distance traveled, number of tire revolutions, vehicle speed, amounts of tread wear, amounts of tire deflection, the amount of static and/or dynamic forces acting on a tire, etc. So many different types of information are possible in part because a microcontroller can be configured to modulate any type of desired data on the RF output signal(s) from the electronics assembly and the subject calibration methodologies are able to insure reliable interpretation of the transmitted data.

Having recognized the above mentioned positive aspect associated with SAW based devices, the present subject matter recognizes and addresses the fact that there are, never the less, negative aspects associated with SAW based devices that are based on the retransmission of RF energy. Significant among these aspects is the variation in calibration points of individual SAW devices based on manufacturing tolerances as well as variations produced as a result of actual post manufacturing installation processes.

In accordance with aspects of certain embodiments of the present subject matter, methodologies are provided to take into consideration variations inherent in individual sensor data output signals based on physical and environmental parameters.

In accordance with certain aspects of other embodiments of the present subject matter, methodologies have been developed to compensate for inherent individual sensor variations so that uniformly accurate and reproducible data may be collected.

In accordance with yet additional aspects of further embodiments of the present subject matter, methodologies have been developed to obtain and store individual calibration coefficients for SAW based sensors.

According to yet still other aspects of additional embodiments of the present subject matter, methodologies have been developed to provide ready access to stored calibration coefficients for association with individual SAW based sensors.

### BRIEF DESCRIPTION OF THE DRAWINGS

A full and enabling disclosure of the present invention, including the best mode thereof, directed to one of ordinary skill in the art, is set forth in the specification, which makes reference to the appended figures, in which:

Figure 1 diagrammatically illustrates an operational relationship between an interrogator and a SAW based device mounted in a tire according to known practices;

Figure 2 illustrates a basic operational relationship between a handheld interrogator and a SAW based device;

Figure 3 illustrates a basic operational configuration of a vehicle drive through interrogator arrangement; and

Figure 4 illustrates a basic configuration of a SAW based device including a memory component with which the methodologies of the present subject matter may be applied.

Repeat use of reference characters throughout the present specification and appended drawings is intended to represent same or analogous features or elements of the invention.

### DETAILED DESCRIPTION OF THE PREFERRED EMBODIMENTS

As discussed in the Summary of the Invention section, the present subject matter is particularly concerned with an improved methodology for providing accurate sensor information based on data read from SAW based devices.

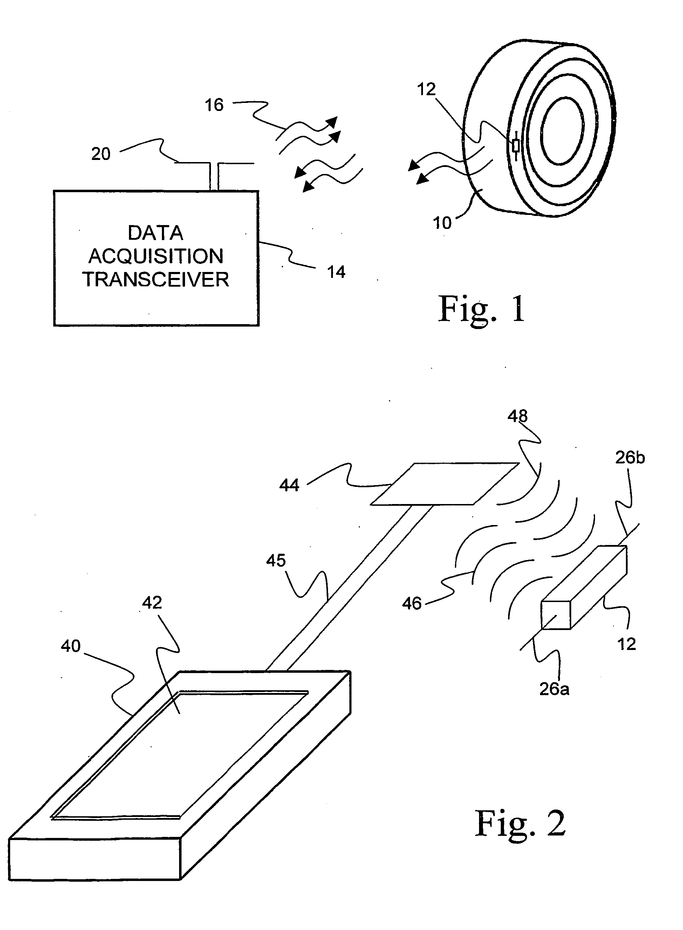

Reference will now be made in detail to the presently preferred embodiments of the subject tire electronics assemblies. Referring now to the drawings, Figure 1 illustrates aspects of a known tire monitoring system with a passively operating electronics assembly, including a condition-responsive device, such as an acoustic wave sensor. Tire structure 10 may incorporate a condition-responsive device 12 to monitor various physical parameters such as temperature or pressure within the tire or associated wheel assembly. Such a condition-responsive device may include at least one resonator-type sensor, such as a surface acoustic wave (SAW) resonator or a bulk acoustic wave (BAW) resonator. It should be appreciated in accordance with the present technology that a condition-responsive device can correspond to either of these specific types of sensors or to any commercially available acoustic wave sensor or other type of sensor that is resonant at a suitable frequency or frequencies. The passively operating assembly with condition-responsive device 12 of Fig. 1 may be energized by a remote source. Thus, a data acquisition transceiver 14 is typically provided with both transmitter and receiver electronics to communicate with the condition-responsive device 12. RF pulses 16 transmitted from the antenna 20 of the transceiver 14 to the electronics assembly in tire 10 excite the SAW device, which may then store some of this energy and transmit a signal back to the transceiver at the end of each energizing RF pulse.

Referring still to Fig. 1, transceiver 14 transmits an interrogation signal 16 that is intended to energize a given condition-responsive device 12 at its frequency of natural oscillation (resonant frequency) such that after an excitation pulse, each resonator element in condition-responsive device 12 radiates energy stored during excitation. Peak levels of this radiated energy occur at the respective resonant frequencies of the resonator elements in the condition-responsive device 12. Such signals are then received at the transceiver 14. By monitoring changes in the frequency of the signal transmitted back from condition-responsive device 12, information corresponding to preselected condition(s) within tire structure 10 can be determined.

In accordance with aspects of the present invention, a condition-responsive device 12 may be provided that relays information in addition to the parameters sensed merely by the condition-responsive device itself. Such information may include, but is not limited to, data relating to the specific tire to which the condition-responsive device 12 is associated including manufacturing information, tire information, and other types of data as may be of interest. In accordance with the present technology, the condition-responsive device 12 may also relay data associated with the specific SAW based sensor(s) with which it is associated. More particularly, calibration coefficients related to the specific SAW based sensor(s) with which it is associated may be stored along with the other types of data previously mentioned in a memory associated with the condition-responsive device 12 as will be described more completely later.

Condition-responsive device 12 may be provided in conjunction with a tire structure in a variety of fashions. For instance, condition-responsive device 12 may be attached to the interior of a tire structure or some other location relative to a wheel assembly. Alternatively, condition-responsive device 12 may be embedded within a tire structure itself. Still further, condition-responsive device 12 may be encased in an elastomer material with appropriate dielectric properties that may then be adhered to or embedded within a tire structure. The condition-responsive device 12 may also be packaged in any number of ways and may be attached to the wheel assembly, the valve stem, or in any other place which allows for substantially accurate measurement of environmental conditions such as temperature and pressure as associated with the tire.

In accordance with the variety of possible locations for condition-responsive device 12, it will be appreciated in accordance with the present subject matter that a condition-responsive device "integrated" with a tire structure or wheel assembly is intended to encompass all such possible locations and others as within the purview of one of ordinary skill in the art. As recognized in accordance with the present technology, however, this variety of multiple location possibilities for condition-responsive device 12 may contribute in part to variations in sensor response from the sensor(s) within the condition-responsive device 12.

While a surface acoustic wave (SAW) device has many advantages as a pressure and temperature sensor, the manufacturing tolerances as well as the non-uniformity of the wafer thickness, require that a calibration be performed on each device. Furthermore, when the SAW package is cured into a rubber patch or onto a rubber surface, the resultant stresses on the package are not applied with sufficient repeatability and reproducibility, thus requiring an in-patch calibration. The result of an individual calibration is that, to read the device with sufficient accuracy, repeatability and reproducibility these coefficients must be applied to the frequencies read by the interrogator. Thus, there is a need to associate with each device its unique calibration coefficients.

One solution to the problem of calibration coefficient storage would be to physically attach or embed a radio frequency identification transponder into or onto each patch containing the SAW device. The required calibration coefficients would be written onto the RFID transponder at the time of calibration of the SAW device. In operation, an RFID interrogator would first read the calibration coefficients stored on the RFID transponder in the patch as well as the patch unique identification number. Next, the SAW interrogator would read the frequencies of the SAW resonators corresponding to the sensed temperature and pressure. The calibrated temperature and pressure parameters then would be calculated using the appropriate mathematical formulas involving these calibration coefficients.

With reference now to Figure 2, there is illustrated an exemplary embodiment of a handheld interrogator 40 for use with condition-responsive device 12. Interrogator 40 includes a display panel 42 for displaying data read from condition-responsive device 12 and may also display other information relative to the interrogator 40 itself, for example, battery level or software version information. Display panel 42 may also be configured as a "touch" panel so as to perform the dual purpose of display and input control for the interrogator 40. Alternatively, control elements (not shown) may be mounted to the exterior of the interrogator to provide control of it's various functions. An antenna 44 is mounted to interrogator 40's main hosing and supported remotely from the main housing by a support element 45.

In normal operation, interrogator 40 may be programmed to transmit one or more signals 48 to condition-responsive device 12. These signals, received by the condition-responsive device 12 via antennae 26a, 26b, may be used to instruct the condition-responsive device 12 to transmit collected and/or otherwise stored data to be read by the interrogator 40. The transmitted signal 48 may also be rectified by elements within condition-responsive device 12 to supply operating power to the device. Alternatively, depending on the specific type of condition-responsive device 12 involved, interrogator 40 may only be required to read continuously or intermittently transmitted signals 46 transmitted autonomously by condition-responsive device 12. There is the possibility also that the mutual operation of interrogator 40 and condition-responsive device 12 may require some combination of the two previously discussed operational modes. For example, interrogator 40 may not function as the power source for the condition-responsive device, but may be required to send a signal instructing the condition-responsive device 12 to "download" or transmit data. All such variations in operational characteristics are considered to be within the scope of the present subject matter.

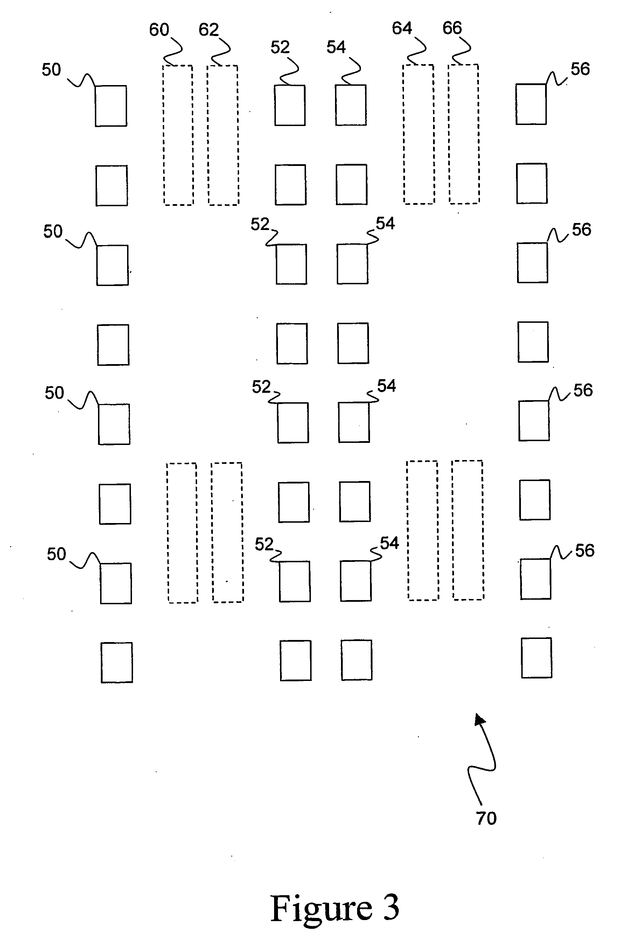

With reference now to Figure 3, another exemplary embodiment of an interrogator usable in association with the present subject matter will now be described. Illustrated in Figure 3 is an exemplary configuration of a drive-by interrogator arrangement. In this exemplary configuration, a plurality of interrogators 50, 52, 54, 56 are arranged in an array of four columns, each containing eight interrogators. As should be evident to those of ordinary skill in the art, the exact total number of interrogators included in such an array would depend on the specific use to which the array is placed. In the presently illustrated exemplary configuration, the array of interrogators is configure to permit a multi-wheeled vehicle to pass through a lane 70 with the interrogators positioned in such manner as to allow the tires 60, 62, 64, 66 of such a vehicle to pass between adjacent columns of interrogators. In this manner and under normal operations interrogator 50 is in a position to read data from tire 60 while interrogator 62 reads data from tire 62, interrogator 54 from tire 64, and interrogator 56 from tire 66.

As previously noted, one of the aspects involved with the operation of interrogator and RFID electronics assembly combinations is the dependency of system accuracy and performance on the calibration of the SAW sensor(s) signals transmitted from the condition-responsive device 12 to interrogator 40. There is, therefore, a need to be able to compensate for any manufacturing or installation produced variations that may adversely affect the accuracy of read data. As previously discussed, such compensation, in accordance with the present technology, may take the form of providing individual calibration coefficients stored within a memory portion of an RFID device or some other memory containing device that may already be associated with a tire or wheel and with which a uniquely identifiable SAW sensor may also be associated.

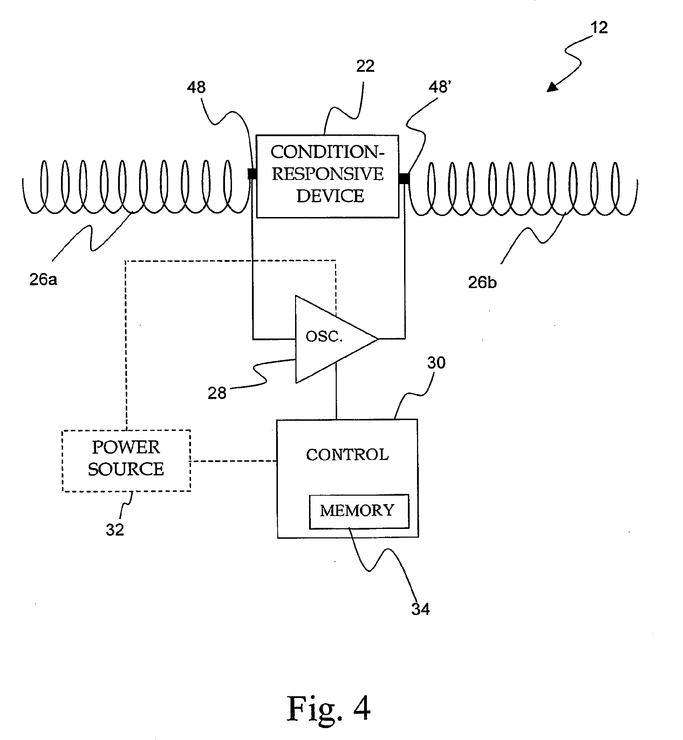

Referring now to Fig. 4, an electronics assembly 12 for monitoring predetermined conditions within a tire structure or corresponding wheel assembly is illustrated. Electronics assembly 12 may be provided in conjunction with a tire structure in a variety of fashions. For instance, electronics assembly 12 may be attached to the interior of a tire structure or some other location relative to a wheel assembly. Alternatively, electronics assembly 12 may be embedded within a tire structure itself. Still further, electronics assembly 12 may be encased in an elastomer material with appropriate dielectric properties that may then be adhered to or embedded within a tire structure. The electronics assembly 12 may also be packaged in any number of ways and may be attached to the wheel assembly, the valve stem, or in any other place which allows for substantially accurate measurement of environmental conditions such as temperature and pressure as associated with the tire. In accordance with the variety of possible locations for electronics assembly 12, it will be appreciated in accordance with the present subject matter that an electronics assembly "integrated" with a tire structure or wheel assembly is intended to encompass all such possible locations and others as within the purview of one of ordinary skill in the art.

Electronics assembly 12 preferably includes a condition-responsive device 22, such as a sensor based on acoustic wave technology, which is capable of sensing various information about given tire conditions, such as temperature and pressure. A specific example of a condition-responsive device for use in accordance with embodiments of the present invention is a SAW device as developed by TRANSENSE TECHNOLOGIES, PLC. Specific aspects of such a SAW device are disclosed in published U. S. Patent Application No. 10/057,460, which is incorporated herein by reference for all purposes. Such a SAW device includes at least three resonator elements, each operating at a different resonant frequency. One specific example of three different resonant frequencies that may be simultaneously radiated for a given combination of environmental conditions is 433.28 MHz, 433.83 MHz, and 434.26 MHz. Each resonance shifts slightly in response to one or more parameters being sensed. Three resonator elements in combination yield a condition-responsive device that provides sufficient information to determine both the temperature and pressure levels in a tire. The resonant frequencies for such multiple resonator elements are preferably designed such that the distance between adjacent resonant frequencies is always greater than the resonator bandwidths at any pressure or temperature condition within a tire.

In an exemplary configuration condition-responsive device 22 may be configured as a single port device with two or more physical connection points 48, 48' to the single port. An oscillator circuit 28 and a pair of helical antenna elements 26a, 26b are connected to the condition-responsive device's input port via such electrical connection points 48, 48'. The condition-responsive device 22 provides tire related data by way of changes in resonant frequencies as previously discussed while the oscillator 28, in combination with control circuit 30 may be employed to provide additional data as will be described later. Oscillator circuit 28 may be designed to have many various circuit configurations, and may be provided by a single amplifier element (such as an operational amplifier, a field-effect transistor (FET), a bipolar junction transistor (BJT), or other type of transistor) or by an integrated circuit such as one including an amplifier element in selective combination with other active and/or passive components such as but not limited to resistors, inductors, diodes, capacitors, transistors and others as required to implement a combination of positive feedback and appropriate phase shift as required for effective oscillation. An additional exemplary configuration for the oscillator circuit 28 is a Colpitts oscillator, as is well known to those of ordinary skill in the art.

Helical antenna elements 26a, 26b, connected to the input port of condition-responsive device 22, facilitate detection of condition-induced changes in resonant frequencies of the condition-responsive device 22. The helical antenna elements 26a, 26b also serve as transmission elements for signals generated by oscillator 28. Although antenna elements 26a, 26b are exemplarily illustrated and described as helical elements, it should be borne in mind that other configurations including as non-limiting examples straight or curved configurations as well as lengths that are optimized for desired radiation performance may be used. It should be appreciated in accordance with the present subject matter that utilization of other antenna configurations, such as monopole antennas, loop antennas, or others as within the purview of one of ordinary skill in the art, is within the spirit and scope of the present invention.

Referring still to Fig. 4, a controller 30 may also be connected to oscillator circuit 28 to provide a means for selectively switching the oscillator 28 on and off, thus providing the capability of superimposing a digital data stream on the RF signal radiated from the antenna embodied by antenna elements 26a and 26b. By selectively controlling operating power from, for example, power source 32 to the oscillator circuit 28, data is effectively modulated at the condition-responsive device 22. The controller 30 providing such ON/OFF modulation may correspond to a microcontroller with optionally varied degrees of functionality. Specific information may be stored in an onboard memory 34 associated with controller 30 and an output signal indicative of such specific information may be employed by the controller 30 to control the power supply to oscillator 28 to modulate that specific data on the RF signals radiated by antenna elements 26a, 26b coupled to condition-responsive device 22. In accordance with the present technology, SAW sensor specific calibration constants may be stored in memory 34 such that these constants may be read therefrom and used in appropriate mathematical calculations to provide appropriate corrections for the sensed monitored parameters.

In other embodiments of the present invention, controller 30 may correspond to a radio frequency identification (RFID) chip. RFID chips often include their own microcontroller that can be employed to selectively control the connection between controller 30 and oscillator circuit 28. An RFID microcontroller may be characterized by limited functionality and thus provision of an additional control element in such instances is within the spirit and scope of embodiments of the present invention.

As previously mentioned, an aspect of the present technology is that the subject SAW based assemblies may transmit a combination of information. A data signal radiated from exemplary electronics assembly 12 may carry two independent streams of information. The first stream of information is the digital information effected by an ON/OFF modulation provided via the coupling from controller 30 to oscillator circuit 28. The second stream of information is determined by the resonant frequencies of the condition-responsive device 22 (which depend on the physical parameters being sensed). In some configurations, condition-responsive device 22 may include a plurality of resonator elements each configured to operate at a slightly different resonant frequency and each of those frequencies will vary slightly depending on the state(s) of the physical condition the sensor is monitoring. By monitoring the values of these distinct resonant frequencies, information concerning temperature, pressure, or other conditions associated with a tire can be interpolated. For instance, in one exemplary SAW sensor embodiment having three respective resonator elements, one resonant frequency can be interpolated to represent a given pressure value and a temperature value can be interpreted from a differential of the other two resonant frequencies.

Referring again to Fig. 4, electronics assembly 12 may optionally be configured as an active assembly, whereby a power source 32 may be provided to power selected elements of the assembly 12, such as the oscillator circuit 28 and the controller 30. In some embodiments, power source 32 may be a battery, such as but not limited to a rechargeable battery. In other embodiments, power source 32 may be an internal power generation device such as one that includes piezoelectric elements configured to convert mechanical energy from tire rotation to electrical energy that may then be stored therein. An example of a power generation device for utilization with the present subject matter is disclosed in currently pending U. S. Patent Application No. 10/143,535, entitled "System and Method for Generating Electric Power from a Rotating Tire's Mechanical Energy Using Piezoelectric Fiber Composites," which is incorporated by reference herein for all purposes. In other applications where a power source 32 is not provided as an integrated component of electronics assembly 12, power may be inductively coupled from a wheel well to the electronics assembly in a tire or rectified RF power may alternatively be utilized. It should be appreciated that any type of specific power source may be employed, while still remaining within the spirit and scope of the present subject matter.

## Claims

1. A method for compensating data readings from a sensor (12, 22), comprising the steps of:
providing a sensor (12, 22) for producing data readings;
associating the sensor (12, 22) with an item (10) to be monitored; determining calibration coefficients for the sensor (12, 22);
providing a memory (34) in proximity to the sensor (12, 22); and
storing the calibration constants determined in the step of determining in the memory (34),
**characterized in that** the step of determining the calibration coefficients is performed subsequent to the step of associating.

2. The method of claim 1, further comprising the steps of;
providing an interrogator (40; 50, 52, 54, 56) for reading data from the sensor (12, 22) and memory (34);
reading the calibration constants from the memory (34);
reading data from the sensor (12, 22); and
modifying the data read from the sensor (12, 22) as a function of the calibration constants.

3. The method of claim 1, wherein the step of providing a memory (34) comprises configuring a portion of a memory (34) of an RFID device to store the calibration constants.

4. The method of claim 1, wherein the step of providing a memory (34) comprises associating a memory device with the sensor (12, 22).

5. The method of claim 1, wherein the step of providing a sensor (12, 22) comprises providing a surface acoustic wave (SAW) based sensor.

## Patentansprüche

1. Verfahren zum Kompensieren der Messwerte von einem Sensor (12, 22), das die folgenden Schritte umfasst:
Vorsehen eines Sensors (12, 22) zum Erzeugen von Messwerten; Zuordnen des Sensors (12, 22) zu einem zu überwachenden Element (10);
Bestimmen von Kalibrierungskoeffizienten für den Sensor (12, 22); Vorsehen eines Speichers (34) in der Nähe des Sensors (12, 22); und
Speichern der in dem Schritt des Bestimmens bestimmten Kalibrierungskonstanten in dem Speicher (34),
**dadurch gekennzeichnet, dass** der Schritt des Bestimmens der Kalibrierungskoeffizienten nach dem Schritt des Zuordnens ausgeführt wird.

2. Verfahren nach Anspruch 1, das ferner die folgenden Schritte umfasst:
Vorsehen einer Abfrageeinrichtung (40; 50, 52, 54, 56) zum Lesen der Daten von dem Sensor (12, 22) und aus dem Speicher (34); Lesen der Kalibrierungskonstanten aus dem Speicher (34);
Lesen der Daten von dem Sensor (12, 22); und
Ändern der von dem Sensor (12, 22) gelesenen Daten als Funktion der Kalibrierungskonstanten.

3. Verfahren nach Anspruch 1, bei dem der Schritt des Vorsehens eines Speichers (34) das Konfigurieren eines Abschnitts eines Speichers (34) einer RFID (Radio Frequency Identification - Identifizierung mit Hilfe elektromagnetischer Wellen)-Vorrichtung zum Speichern der Kalibrierungskonstanten umfasst.

4. Verfahren nach Anspruch 1, bei dem der Schritt des Vorsehens eines Speichers (34) das Zuordnen einer Speichervorrichtung zu dem Sensor (12, 22) umfasst.

5. Verfahren nach Anspruch 1, bei dem der Schritt des Vorsehens eines Sensors (12, 22) das Vorsehen eines Sensors auf der Grundlage akustischer Oberflächenwellen (SAW - Surface Acoustic Wave) umfasst.

## Revendications

1. Procédé pour la compensation de lectures de données provenant d'un capteur (12, 22), comprenant les étapes consistant à:
procurer un capteur (12, 22) pour produire des lectures de données;
associer le capteur (12, 22) avec un élément (10) à surveiller;
déterminer des coefficients d'étalonnage pour le capteur (12, 22);
procurer une mémoire (34) à proximité du capteur (12, 22); et
enregistrer dans la mémoire (34) les constantes d'étalonnage établies dans l'étape de détermination,
**caractérisé en ce que** l'étape de détermination des coefficients d'étalonnage est mise en oeuvre après l'étape d'association.

2. Procédé selon la revendication 1, comprenant en outre les étapes consistant à;
procurer un interrogateur (40; 50, 52, 54, 56) pour lire des données du capteur (12, 22) et de la mémoire (34);
lire les constantes d'étalonnage provenant de la mémoire (34);
lire des données du capteur (12, 22); et
modifier les données lues du capteur (12, 22) en fonction des constantes d'étalonnage.

3. Procédé selon la revendication 1, dans lequel l'étape de procuration d'une mémoire (34) comprend la configuration d'une portion de mémoire (34) d'un dispositif de radio-identification (RFID - radio frequency identification) pour enregistrer les constantes d'étalonnage.

4. Procédé selon la revendication 1, dans lequel l'étape de procuration d'une mémoire (34) comprend l'association d'un dispositif de mémoire avec le capteur (12, 22).

5. Procédé selon la revendication 1, dans lequel l'étape de procuration d'un capteur (12, 22) comprend la procuration d'un capteur fonctionnant selon le principe des ondes acoustiques de surface (SAW - Surface Acoustic Wave).
